# EUROPEAN PATENT APPLICATION

(11) **EP 2 413 456 A1**
(43) Date of publication of application: **01.02.2012**
(21) Application number: 11166900.8
(22) Date of filing: 20.05.2011
(51) Int. Cl.: H02J 7/00, H01H 9/54, H01M 10/50, H02M 5/00

(54) **Battery heating circuit**

(30) Priority: 30.07.2010 CN 201010245288; 30.08.2010 CN 201010274785; 31.03.2011 CN 201110080853
(71) Applicant: Byd Company Limited, Shenzhen 518118 (CN)
(72) Inventor: Xu, Wenhui, 518118, Shenzhen (CN); Han, Yaochuan, 518118, Shenzhen (CN); Feng, Wei, 518118, Shenzhen (CN); Yang, Qinyao, 518118, Shenzhen (CN); Xia, Wenjin, 518118, Shenzhen (CN); Ma, Shibin, 518118, Shenzhen (CN)
(74) Representative: Fritsche, Daniel

(57) **Abstract**

The present invention provides a battery heating circuit, wherein: a battery E, a damping element R1, a current storage element L1, a switch unit DK1 and a charge storage element C1 are connected in series to form a battery discharging circuit; a current storage element L2 is connected with an one-way semiconductor element D3 in series, and then the series circuit composed of the current storage element L2 and one-way semiconductor element D3 is connected in parallel to the ends of the switch unit DK1; the charge storage element C1, current storage element L2 and one-way semiconductor element D3 are connected in series in sequence to form a battery back-charging circuit; and a switch unit DK2 is connected in parallel to the ends of the serially connected charge storage element C1 and current storage element L2, and works together with the current storage element L2 to form a voltage regulation and polarity inversion circuit for the charge storage element C1. In the present invention, the voltage across the charge storage element C1 can be regulated flexibly by controlling the switch unit DK2 in the voltage regulation and polarity inversion circuit.

## Description

### Technical Field of the Invention

The present invention pertains to electric and electronic field, in particular to a battery heating circuit.

### Background of the Invention

In view cars have to run under complex road conditions and environmental conditions or some electronic devices are used under harsh environmental conditions, the battery, which serves as the power supply unit for electric motor cars or electronic devices, must be adaptive to these complex conditions. In addition, besides these conditions, the service life and charging/discharging cycle performance of battery must be considered; especially, when electric motor cars or electronic devices are used in low temperature environments, the battery must have outstanding low temperature charging/discharging performance and higher input/output power.

Usually, under low temperature conditions, the resistance of battery will increase, and the polarization will increase; therefore, the capacity of battery will be reduced.

To keep the capacity of battery and improve the charging/discharging performance of battery under low temperature conditions, the present invention provides a battery heating circuit.

### Summary of the Invention

The object of the present invention is to provide a battery heating circuit, in order to solve the problem of decreased capacity of battery caused by increased resistance and polarization of battery under low temperature conditions.

the present invention provides a battery heating circuit, wherein: a battery E, a damping element R1, a current storage element L1, a switch unit DK1 and a charge storage element C1 are connected in series to form a battery discharging circuit; a current storage element L2 is connected with an one-way semiconductor element D3 in series, and then the series circuit composed of the current storage element L2 and one-way semiconductor element D3 is connected in parallel to the ends of the switch unit DK1; the charge storage element C1, current storage element L2, and one-way semiconductor element D3 are connected in series in sequence to form a battery back-charging circuit; and a switch unit DK2 is connected in parallel to the ends of the serially connected charge storage element C1 and current storage element L2, and works together with the current storage element L2 to form a voltage regulation and polarity inversion circuit for the charge storage element C1.

In the present invention, since the battery back-charging circuit and the voltage regulation and polarity inversion circuit share the same current storage element L2, and therefore the number of required elements is decreased. In addition, by controlling the switch unit DK2 in the voltage regulation and polarity inversion circuit, the remaining energy in the charge storage element C 1 can be further charged back into the battery E after the battery back-charging circuit charges back the electric energy stored in the charge storage element C1 partially to the battery E, and thereby the voltage across the charge storage element C1 can be regulated flexibly.

Other characteristics and advantages of the present invention will be further detailed in the embodiments hereunder.

### Brief Description of the Drawings

The accompanying drawings are provided here to facilitate further understanding on the present invention, and are a part of this document. They are used together with the following embodiments to explain the present invention, but shall not be comprehended as constituting any limitation to the present invention. In the figures:
Figure 1 is a schematic diagram of the battery heating circuit in the first embodiment of the present invention;
Figure 2 is a timing sequence diagram of waveform of the battery heating circuit shown in Figure 1;
Figure 3 is another timing sequence diagram of waveform of the battery heating circuit shown in Figure 1;
Figure 4 is a circuit diagram of the battery heating circuit in the second embodiment of the present invention;
Figure 5 is a timing sequence diagram of waveform of the battery heating circuit shown in Figure 4;
Figure 6 is a circuit diagram of the battery heating circuit in the third embodiment of the present invention; and
Figure 7 is a timing sequence diagram of waveform of the battery heating circuit shown in Figure 6.

### Detailed Description of the Embodiments

Hereunder the embodiments of the present invention will be detailed, with reference to the accompanying drawings. It should be appreciated that the embodiments described here are only provided to describe and explain the present invention, but shall not be deemed as constituting any limitation to the present invention.

Please note: unless otherwise specified, where mentioned in the following text, the term "switching control module" refers to any controller that can output control commands (e.g., pulse waveform) under preset conditions or at preset times and thereby controls the switch unit connected to it to switch on or switch off accordingly, for example, the switching control module can be a PLC; where mentioned in the following text, the term "switch" refers to a switch that achieve ON/OFF control by means of electrical signals or achieve ON/OFF control on the basis of the characteristics of the element or component, which is to say, the switch can be an one-way switch (e.g., a switch composed of a two-way switch and a diode connected in series, which can switch on in one direction) or a two-way switch (e.g., a Metal Oxide Semiconductor Field Effect Transistor (MOSFET) or an IGBT with an anti-parallel freewheeling diode); where mentioned in the following text, the term "two-way switch" refers to a switch that can switch on in two ways, which can achieve ON/OFF control by means of electrical signals or achieve ON/OFF control on the basis of the characteristics of the element or component, for example, the two-way switch can be a MOSFET or an IGBT with an anti-parallel freewheeling diode; where mentioned in the following text, the term "one-way semiconductor element" refers to a semiconductor element that can switch on in one direction, such as an diode; where mentioned in the following text, the term "charge storage element" refers to any device that can implement charge storage, such as a capacitor; where mentioned in the following text, the term "current storage element" refers to any device that can store current, such as an inductor; where mentioned in the following text, the term "forward direction" refers to the direction in which the energy flows from the battery to the energy storage circuit, and the term "reverse direction" refers to the direction in which the energy flows from the energy storage circuit to the battery; where mentioned in the following text, the term "battery" comprises primary battery (e.g., dry battery or alkaline battery, etc.) and secondary battery (e.g., lithium-ion battery, nickel-cadmium battery, nickel-hydrogen battery, or lead-acid battery, etc.); where mentioned in the following text, the term "damping element" refers to any device that inhibits current flowing and thereby achieves energy consumption, such as a resistor; where mentioned in the following text, the term "main loop" refers to a loop composed of battery, damping element, switch unit and energy storage circuit connected in series.

It should be noted specially: in view different types of batteries have different characteristics, in the present invention, the "battery" refers to an ideal battery that doesn't have internal parasitic resistance and inductance or has very low internal parasitic resistance and inductance, or refers to a battery pack that has internal parasitic resistance and inductance; therefore, those skilled in the art should appreciate: if the battery is an ideal battery that doesn't have internal parasitic resistance and inductance or has very low internal parasitic resistance and inductance, the damping element refers to an damping element external to the battery, and the current storage element L1 refers to an current storage element external to the battery; if the battery is a battery pack that has internal parasitic resistance and inductance, the damping element refers to a damping element external to the battery, or refers to the parasitic resistance in the battery pack; likewise, the current storage element L1 refers to a current storage element external to the battery, or refers to the parasitic inductance in the battery pack.

To ensure the normal service life of the battery, the battery can be heated under low temperature condition, which is to say, when the heating condition is met, the heating circuit is controlled to start heating for the battery; when the heating stop condition is met, the heating circuit is controlled to stop heating.

In the actual application of battery, the battery heating condition and heating stop condition can be set according to the actual ambient conditions, to ensure normal charging/discharging performance of the battery.

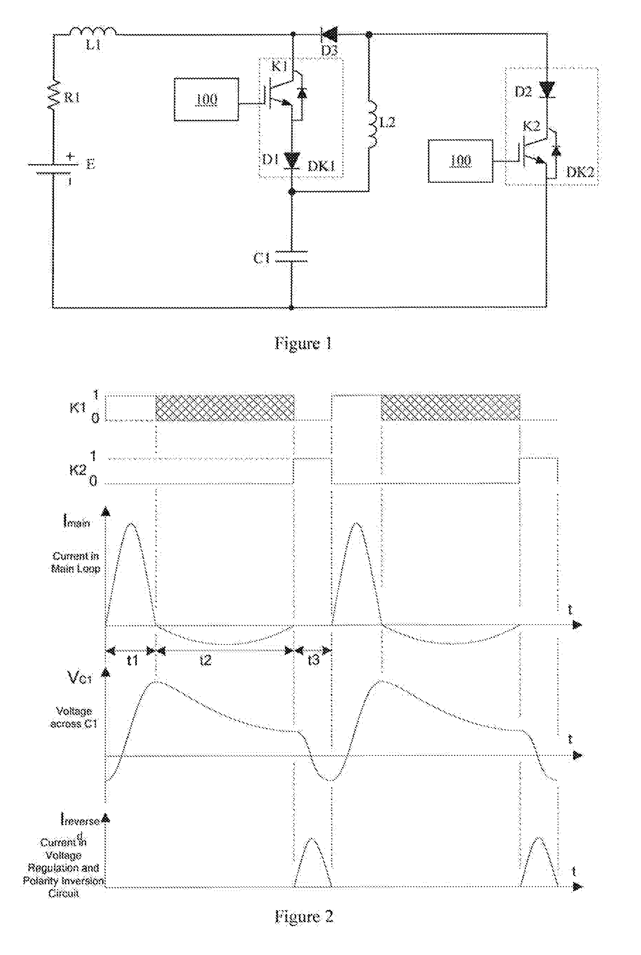

Figure 1 is a schematic diagram of the battery heating circuit in the first embodiment of the present invention. As shown in Figure 1, the present invention provides a battery heating circuit, wherein: a battery E, a damping element R1, a current storage element L1, a switch unit DK1 and a charge storage element C1 are connected in series to form a battery discharging circuit; a current storage element L2 is connected with an one-way semiconductor element D3 in series, and then the series circuit composed of the current storage element L2 and one-way semiconductor element D3 is connected in parallel to the ends of the switch unit DK1; the charge storage element C1, current storage element L2 and one-way semiconductor element D3 are connected in series in sequence to form a battery back-charging circuit; and a switch unit DK2 is connected in parallel to the ends of the serially connected charge storage element C1 and current storage element L2, and works together with the current storage element L2 to form a voltage regulation and polarity inversion circuit for the charge storage element C1.

Wherein, the damping element R1 and current storage element L1 can be the parasitic resistance and inductance in the battery E respectively. The switch unit DK1 can comprise a switching element K1 and a one-way semiconductor element D1 connected in series with each other, and the switch unit DK2 can comprise a switching element K2 and a one-way semiconductor element D2 connected in series with each other. The present invention is not limited to those elements. Any other elements that can achieve one-way conduction function are also applicable.

Wherein, the heating circuit further comprises a switching control module 100, which is electrically connected with the switch unit DK1 and switch unit DK2, and is configured to: control the switch unit DK1 to switch on and control the switch unit DK2 to switch off, so that the electric energy in the battery E can be charged into the charge storage element C1; in the process that the electric energy in the battery E is charged into the charge storage element C1, when the current flowing through the battery E reaches to zero after the positive half cycle, control the switch unit DK1 to switch off, so that the electric energy stored in the charge storage element C1 can be charged back into the battery E; in the process that the electric energy stored in the charge storage element C1 is charged back to the battery E, when the current flowing through the battery E reaches to zero after the negative half cycle, control the switch unit DK2 to switch on, so that the electric energy stored in the charge storage element C1 can be charged into the current storage element L2, and then charged back from the current storage element L2 to the charge storage element C1; and, when the current flowing through the voltage regulation and polarity inversion circuit reaches to zero after the positive half cycle, control the switch unit DK2 to switch off, so that the polarity of the charge storage element C1 is inverted. In that process, by keeping to-and-fro electric energy flow between the battery E, charge storage element C1 and current storage element L2, current flowing through the battery E is maintained, so that the battery E is heated up by itself.

Figure 2 is a timing sequence diagram of waveform of the battery heating circuit shown in Figure 1. Hereunder the control exercised by the switching control module 100 will be described with reference to Figure 2, wherein, the current Iₘₐᵢₙ in the main loop represents the current flowing through the battery E, V_{c1} represents the voltage across the charge storage element C1, the current I_{reversed} represents the current flowing through the voltage regulation and polarity inversion circuit, i.e., the current flowing through the switch unit DK2. First, the switching control module 100 controls the switch unit DK1 to switch on, and controls the switch unit DK2 to switch off, so that the electric energy in the battery E can be charged into the charge storage element C1 (see the time period t1 in Figure 2); next, when the current flowing through the battery E reaches to zero after the positive half cycle, the switching control module 100 controls the switch unit DK1 to switch off, so that the electric energy stored in the charge storage element C1 can be charged back to the battery E (see time period t2 in Figure 2); then, when the current flowing through the battery E reaches to zero after the negative half cycle (at this point, the voltage across the charge storage element C1 is equal to the voltage across the battery E, and therefore the remaining electric energy stored in the charge storage element C 1 can't be charged back into the battery E any more), the switching control module 100 controls the switch unit DK2 to switch on, so that the remaining electric energy stored in the charge storage element C 1 can be charged into the current storage element L2, and then charged back from the current storage element L2 to the charge storage element C1 (see the time period t3 in Figure 2); when the current flowing through the voltage regulation and polarity inversion circuit reaches to zero after the positive half cycle, it indicates the polarity inversion of charge storage element C 1 has been accomplished; at that point, the switching control module 100 controls the switch unit DK2 to switch off. Then, the switching control module 100 can control the switch unit DK1 to switch on, to repeat the cycle described above. Thereby, the current flowing through the battery E is maintained, so that the battery is heated up.

Preferably, the switching control module 100 is also configured to: when the current flowing through the voltage regulation and polarity inversion circuit reaches to a first preset value of current, control the switch unit DK2 to switch off, so that the electric energy stored in the current storage element L2 can be sustained and transferred to the battery E; and, step c2): when the current flowing through the voltage regulation and polarity inversion circuit reaches to a second preset value of current, control the switch unit DK2 to switch on, so that the electric energy stored in the charge storage element C1 can be charged into the current storage element L2; the second preset value of current is smaller than the first preset value of current. Above cycle is repeated, till the voltage across the charge storage element C1 reaches to the preset value of voltage. In that way, the voltage across the charge storage element C1 can be controlled flexibly, and can reach to a voltage value below the voltage of the battery E. The first preset value of current can also be used to control the current flowing through the battery E in the current freewheeling state in step c2), to prevent over-current in the back-charging process to the battery E and thereby prevent damage to the battery.

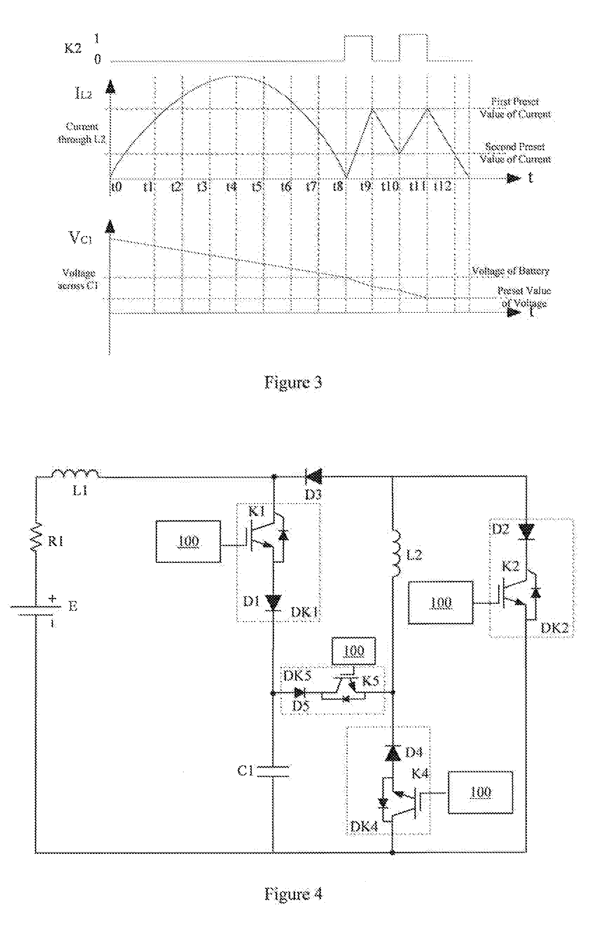

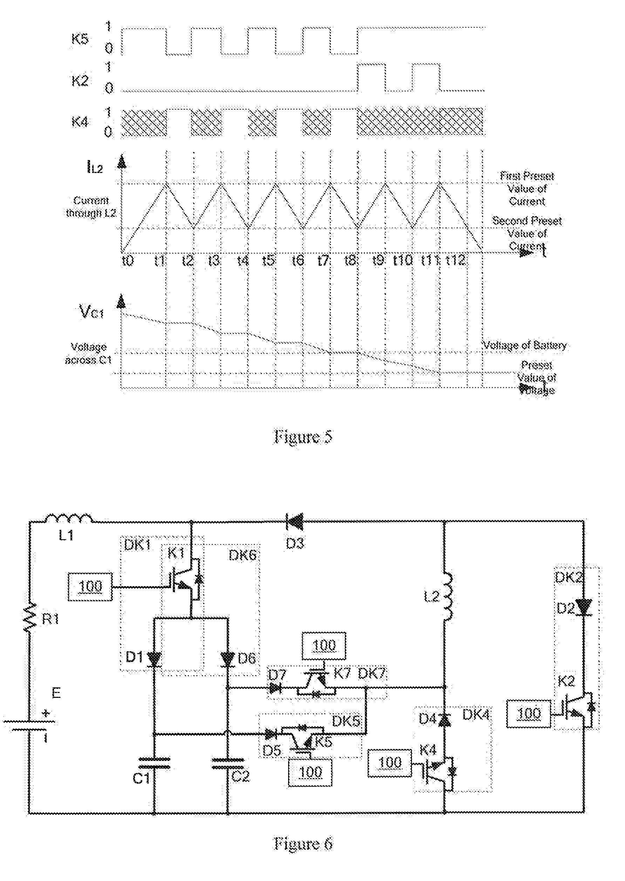

Figure 3 is another timing sequence diagram of waveform of the battery heating circuit shown in Figure 1, wherein, the current I_{L2} represents the current flowing through the current storage element L2, and the voltage V_{c1} represents the voltage across the charge storage element C1. As shown in Figure 3, the time period t0-t8 indicates the back-charging process of the electric energy in charge storage element C1 to the battery E through the battery back-charging circuit; at the end of that process, the voltage across the charge storage element C1 is equal to the voltage across the battery E, and therefore the energy in the charge storage element C 1 can not be charged back to the battery E any more at this point. Then, the switching control module 100 controls the switch unit DK2 to switch on, and thus the electric energy stored in the charge storage element C1 is transferred through the voltage regulation and polarity inversion circuit into the current storage element L2 (see the time period t8-t9 in Figure 3); when the current flowing through the voltage regulation and polarity inversion circuit reaches to the first preset value of current, the switching control module 100 controls the switch unit DK2 to switch off, so that the electric energy stored in the current storage element L2 is sustained and transferred to the battery E (see the time period t9-t10 in Figure 3). After that, when the current flowing through the voltage regulation and polarity inversion circuit reaches to the second preset value of current, the switching control module 100 controls the switch unit DK2 to switch on, so that the electric energy stored in the charge storage element C1 can be further charged to the current storage element L2 (see the time period t10-t11 in Figure 3). Above cycle is repeated, so that the voltage across the charge storage element C 1 is decreased continuously, and finally reaches to the expected voltage. Please note: for the sake of convenience, in Figure 3 and Figure 5, the current flowing through the battery back-charging circuit and the current flowing through the voltage regulation and polarity inversion circuit are represented by the current flowing through the current storage element L2.

Figure 4 is a circuit diagram of the battery heating circuit in the second embodiment of the present invention. As shown in Figure 4, the heating circuit further comprises a switch unit DK4 and a switch unit DK5, wherein, the switch unit DK5 is in the path from the charge storage element C1 to current storage element L2, and the switch unit DK4 is connected in parallel to the ends of the charge storage element C1 for current freewheeling. When the current flowing through the battery back-charging circuit reaches to the first preset value of current, the switch unit DK5 can be controlled to switch off, and the switch unit DK4 can be controlled to switch on, so that the back-charging current in the main loop can be decreased, and therefore damage to the battery E due to over-current in the main loop can be prevented, and the electric energy stored in the current storage element L2 can be sustained and flows to the battery E. When the current flowing through the battery back-charging circuit is decreased to the second preset value of current, the switch unit DK4 can be controlled to switch off, and the switch unit DK5 can be controlled to switch on, so that the electric energy stored in the charge storage element C1 can be charged back again to the battery E via the current storage element L2. Above cycle is repeated, till the voltage across the charge storage element C1 is lower than or equal to the voltage of the battery E.

The heating circuit in the second embodiment of the present invention can comprise a switching control module 100, which is electrically connected with the switch unit DK4 and switch unit DK5, and is configured to perform the following operations: when the current flowing through the battery back-charging circuit reaches to the first preset value of current, the switching control module 100 controls the switch unit DK5 to switch off and controls the switch unit DK4 to switch on, so that the electric energy stored in the current storage element L2 can be sustained and flows to the battery E; and, when the current flowing through the battery back-charging circuit reaches to the second preset value of current, the switching control module 100 controls the switch unit DK4 to switch off and controls the switch unit DK5 to switch on, so that the electric energy stored in the charge storage element C1 can be further charged back to the battery E via the current storage element L2. Above cycle is repeated, till the voltage across the charge storage element C1 is lower than or equal to the voltage of the battery E.

Figure 5 is a timing sequence diagram of waveform of the battery heating circuit shown in Figure 4, wherein, the current I_{L2} represents the current flowing through the current storage element L2, and the voltage V_{C1} represents the voltage across the charge storage element C1. As shown in the time period t0-t8 in Figure 5, when the current flowing through the battery back-charging circuit reaches to the first preset value of current, the switching control module 100 controls the switch unit DK5 to switch off and controls the switch unit DK4 to switch on, so that the electric energy stored in the current storage element L2 can be sustained and flows to battery E via the switch unit DK4 (see the time period t1-t2, t3-t4, t5-t6 and t7-t8 in Figure 5); and, when the current flowing through the battery back-charging circuit reaches to the second preset value of current, the switching control module 100 controls the switch unit DK4 to switch off and controls the switch unit DK5 to switch on, so that the electric energy stored in the charge storage element C1 can be charged to the battery E via the current storage element L2 (see the time period t2-t3, t4-t5 and t6-t7 in Figure 5). Here, with the current freewheeling function of the switch unit DK4, the back-charging current to the battery E is controlled to be lower than the first preset value of current, and therefore damage to the battery E caused by high back-charging current can be prevented.

Figure 6 is a circuit diagram of the battery heating circuit in the third embodiment of the present invention. The heating circuit can further comprise one or more charge storage elements C2 and switch unit DK6 and DK7 corresponding to each charge storage element C2; the battery E, damping element R1, current storage element L1, switch unit DK6 and charge storage element C2 are connected in series to form another battery discharging circuit; the serially connected current storage element L2 and one-way semiconductor element D3 are connected in parallel to the ends of the switch unit DK6, so that the charge storage element C2, current storage element L2 and one-way semiconductor element D3 connected serially in sequence form another battery back-charging circuit, and the switch unit DK7 is in the path from the charge storage element C2 to the current storage element L2. Here, one or more charge storage elements C2 in a configuration similar to the charge storage element C1 are used, and the charge storage element C1 and C2 can charge back the energy stored in them to the battery E via the current storage element L2 in different time periods, so that the energy load on the current storage element L2 is decreased, and therefore a current storage element L2 with lower capacity is enough to match the battery heating circuit.

Wherein, the battery heating circuit in the third embodiment of the present invention further comprises a switching control module 100, which is electrically connected with the switch unit DK1, switch unit DK2, switch unit DK4, switch unit DK5, switch unit DK6 and switch unit DK7, and is configured to control ON/OFF of the switch unit DK1, switch unit DK2, switch unit DK4, switch unit DK5, switch unit DK6 and switch unit DK7, so that the charge storage element C2 and charge storage element C1 are charged at the same time, but discharge and have polarity inversion at different times.

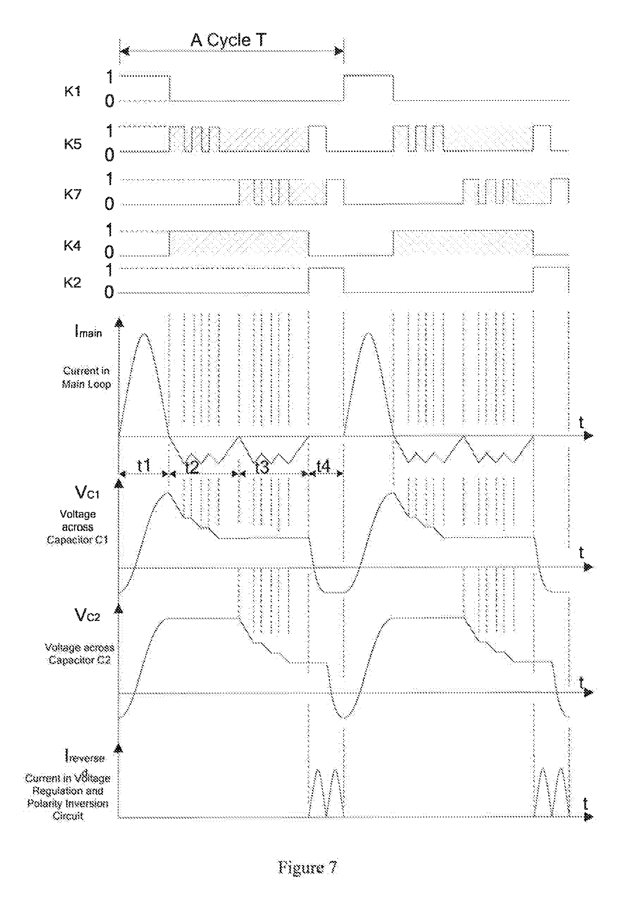

Figure 7 is a timing sequence diagram of waveform of the battery heating circuit shown in Figure 6, wherein, the voltage V_{C1} represents the voltage across the charge storage element C1, while the voltage V_{C2} represents the voltage across the charge storage element C2. Hereunder the operation of the battery heating circuit in the third embodiment of the present invention will be described with reference to Figure 7. The switching control module 100 controls the switch unit DK1 to switch on, and thus the electric energy in the battery E is charged into the charge storage element C1 and C2 (see the time period t1 in Figure 7). When the current Iₘₐᵢₙ in the main loop reaches to zero after the positive half cycle, the switch unit DK1 is controlled to switch off, and the switch unit DK5 is controlled to switch on, so that the electric energy stored in the charge storage element C1 is charged back to the battery E via the current storage element L2; in that period, to protect the battery from damaged by high back-charging current, the switch unit DK4 can be controlled to switch on, and the switch unit DK5 can be controlled to switch on and off intermittently, to attain the purpose of current limiting and freewheeling (see the time period t2 in Figure 7). In the next time period t3, the switch unit DK7 can be controlled similarly to switch unit DK5, so that the electric energy stored in the charge storage element C2 can be charged back to the battery E and the purpose of current limiting and freewheeling can be attained. In the time period t4, the switching control module 100 controls the switch unit DK2 and switch unit DK5 to switch on, to invert the voltage polarity of the charge storage element C1; then, the switching control module 100 controls the switch unit DK5 to switch off, and controls the switch unit DK7 to switch on, to accomplish voltage polarity inversion of the energy storage element C2. The time periods t1-t4 constitute a complete cycle T; the cycle is repeated, to maintain the current flowing through the battery E, so as to attain the purpose of self-heating of the battery.

It should be noted: the switch units mentioned in above description can be composed of a one-way semiconductor element and a switching element, respectively; for example, the switch unit DK3 is composed of a one-way semiconductor element D3 and a switching element K3. Here, the composition of the switch unit DK4-DK7 will not be further described. However, though the switch units shown in the drawings are composed of a one-way semiconductor element and a switching element respectively and are one-way switches, those skilled in the art can envisage that two-way switches can also be used for the switch units to attain the purpose of the present invention, as long as the timing sequential control is appropriate (for example, the control can be exercises on the basis of the timing sequence diagrams shown in Figure 2, Figure 3, Figure 5 and Figure 7). The grid parts in the timing sequence diagrams shown in Figure 2, Figure 5 and Figure 7 are only applicable to the case that the switch units are composed of a one-way semiconductor element and a switching element respectively; in that case, the ON/OFF control of the switching elements in the switch units can be exercised in the grid zones shown in Figure 2, Figure 5 and Figure 7.

In addition, in Figure 6, the switch unit DK6 and switch unit DK1 share the same switching element K1, to reduce the number of switching elements. The "first preset value of current" and "second preset value of current" mentioned above shall be set according to the current endurable by the battery E and other elements/components in the heating circuit, with comprehensive consideration of heating efficiency and protection of battery E against damages, as well as the size, weight and cost of the heating circuit. The "preset value of voltage" can be any expected voltage value.

The present invention has the following advantages: (1) The battery back-charging circuit and the voltage regulation and polarity inversion circuit share the same current storage element L2, and therefore the number of elements can be reduced; (2) the voltage across the charge storage element C1 can be regulated to any value below the voltage of the battery E by controlling the switch unit DK2, to achieve flexible control of the voltage across the charge storage element C1; and (3) the energy load on the current storage element L2 can be alleviated by configuring the charge storage element C1 and arranging one or more charge storage elements C2 in a configuration similar to the charge storage element C 1, so that a current storage element L2 with lower capacity is enough to match the battery heating circuit provided in the present invention.

While some preferred embodiments of the present invention are described above with reference to the accompanying drawings, the present invention is not limited to the details in those embodiments. Those skilled in the art can make modifications and variations to the technical scheme of the present invention, without departing from the spirit of the present invention. However, all these modifications and variations shall be deemed as falling into the protected domain of the present invention.

In addition, it should be noted: the specific technical features described in above embodiments can be combined in any appropriate form, provided that there is no conflict. To avoid unnecessary repetition, the possible combinations are not described specifically in the present invention. Moreover, the different embodiments of the present invention can be combined freely as required, as long as the combinations don't deviate from the ideal and spirit of the present invention. However, such combinations shall also be deemed as falling into the scope disclosed in the present invention.

## Claims

1. A battery heating circuit, wherein:
a battery E, a damping element R1, a current storage element L1, a switch unit DK1 and a charge storage element C1 are connected in series to form a battery discharging circuit;
a current storage element L2 is connected with an one-way semiconductor element D3 in series, and then the series circuit composed of the current storage element L2 and the one-way semiconductor element D3 is connected in parallel to the ends of the switch unit DK1; the charge storage element C1, the current storage element L2 and the one-way semiconductor element D3 are connected in series in sequence to form a battery back-charging circuit; and
a switch unit DK2 is connected in parallel to the ends of the serially connected charge storage element C1 and current storage element L2, and the switch unit DK2 works together with the current storage element L2 to form a voltage regulation and polarity inversion circuit for the charge storage element C1.

2. The heating circuit according to claim 1, wherein, the damping element R1 and the current storage element L1 are the parasitic resistance and inductance of the battery E respectively.

3. The heating circuit according to claim 1, wherein, the switch unit DK1 comprises a switching element K1 and a one-way semiconductor element D1 connected in series with each other, and the switch unit DK2 comprises a switching element K2 and a one-way semiconductor element D2 connected in series with each other.

4. The heating circuit according to claim 1, wherein, the heating circuit further comprises a switching control module (100), which is electrically connected with the switch unit DK1 and the switch unit DK2, and the switching control module (100) is configured to:
control the switch unit DK1 to switch on and control the switch unit DK2 to switch off, so that the electric energy in the battery E is charged into the charge storage element C1;
in the process that the electric energy in the battery E is charged into the charge storage element C1, when the current flowing through the battery E reaches to zero after the positive half cycle, control the switch unit DK1 to switch off, so that the electric energy stored in the charge storage element C1 is charged back to the battery E;
in the process that the electric energy stored in the charge storage element C1 is charged back to the battery E, when the current flowing through the battery E reaches to zero after the negative half cycle, control the switch unit DK2 to switch on, so that the electric energy stored in the charge storage element C1 is charged into the current storage element L2, and then the current storage element L2 charges the electric energy back to the charge storage element C1; and
when the current flowing through the voltage regulation and polarity inversion circuit reaches to zero after the positive half cycle, control the switch unit DK2 to switch off.

5. The heating circuit according to claim 4, wherein, the switching control module (100) is further configured to:
when the current flowing through the voltage regulation and polarity inversion circuit reaches to a first preset value of current, control the switch unit DK2 to switch off, so that the electric energy stored in the current storage element L2 is sustained and flows to the battery E; and
when the current flowing through the voltage regulation and polarity inversion circuit reaches to a second preset value of current, control the switch unit DK2 to switch on, so that the electric energy stored in the charge storage element C 1 is charged into the current storage element L2, wherein the second preset value of current is lower than the first preset value of current.

6. The heating circuit according to claim 1, wherein, the heating circuit further comprises a switch unit DK4 and a switch unit DK5, the switch unit DK5 is in the path from the charge storage element C1 to the current storage element C2, the switch unit DK4 is connected in parallel to the ends of the charge storage element C1, so as to achieve current freewheeling function.

7. The heating circuit according to claim 6, wherein, the heating circuit further comprises a switching control module (100), which is electrically connected with the switch unit DK4 and the switch unit DK5, and the switching control module (100) is configured to:
when the current flowing through the battery back-charging circuit reaches to the first preset value of current, control the switch unit DK5 to switch off, and control the switch unit DK4 to switch on, so that the electric energy stored in the current storage element L2 is sustained and transferred to the battery E through the switch unit DK4; and
when the current flowing through the battery back-charging circuit reaches to the second preset value of current, control the switch unit DK4 to switch off, and control the switch unit DK5 to switch on, so that the electric energy stored in the charge storage element C1 is charged into the battery E through the current storage element L2; wherein the second preset value of current is lower than the first preset value of current.

8. The heating circuit according to claim 6, wherein, the heating circuit further comprises one or more charge storage elements C2 and a switch unit DK6 and a switch unit DK7 corresponding to each charge storage element C2,
the battery E, the damping element R1, the current storage element L1, the switch unit DK6 and the charge storage element C2 are connected in series to form another battery discharging circuit;
the current storage element L2 and one-way semiconductor element D3 connected serially are connected in parallel to the ends of the switch unit DK6, so that the charge storage element C2, the current storage element L2 and the one-way semiconductor element D3 connected in series sequentially form another battery back-charging circuit, and the switch unit DK7 is in the path from the charge storage element C2 to the current storage element L2.

9. The heating circuit according to claim 8, wherein, the heating circuit further comprises a switching control module (100), which is electrically connected with the switch unit DK1, the switch unit DK2, the switch unit DK4, the switch unit DK5, the switch unit DK6 and the switch unit DK7, and the switching control module (100) is configured to control ON/OFF of the switch unit DK1, the switch unit DK2, the switch unit DK4, the switch unit DK5, the switch unit DK6 and the switch unit DK7, so that the charge storage element C2 and the charge storage element C1 are charged at the same time, but discharged and have polarity inversion at different times.
